Europäisches Patentamt

European Patent Office

Office européen des brevets

(11) Veröffentlichungsnummer: **0 214 596**
**A2**

## (12) EUROPÄISCHE PATENTANMELDUNG

(21) Anmeldenummer: 86112110.1

(22) Anmeldetag: 02.09.86

(51) Int. Cl.4: **G03G 13/28**

(30) Priorität: **11.09.85 DE 3532346**

(43) Veröffentlichungstag der Anmeldung:
**18.03.87 Patentblatt 87/12**

(84) Benannte Vertragsstaaten:
**DE FR GB**

(71) Anmelder: **HOECHST AKTIENGESELLSCHAFT**
**Postfach 80 03 20**
**D-6230 Frankfurt am Main 80(DE)**

(72) Erfinder: **Schmitt, Klaus**
**Buschungstrasse 54**
**D-6200 Wiesbaden(DE)**
Erfinder: **Schön, Klaus-Peter**
**Rathenauplatz 14**
**D-6200 Wiesbaden(DE)**
Erfinder: **Riedel, Peter, Phys.Ing.**
**Reiferbornstrasse 2**
**D-6257 Hünfelden(DE)**
Erfinder: **Lingnau, Jürgen, Dr.Dipl.-Chem.**
**Karolingerstrasse 10**
**D-6500 Mainz-Laubenheim(DE)**
Erfinder: **Pliefke, Engelbert, Dr.**
**Fritz-Kalle-Strasse 34**
**D-6200 Wiesbaden(DE)**

(54) **Verfahren zum Herstellen von Druckformen.**

(57) Die Erfindung betrifft ein Verfahren zum Herstellen von Druckformen oder metallisierten Bildern auf elektrophotographischem Wege durch elektrostatisches Aufladen, bildmäßiges Belichten und Betonern einer auf einem elektrisch leitenden Trägermaterial aufgebrachten Photoleiterschicht, Fixieren der mit Toner versehenen Bildstellen, Entfernen der Photoleiterschicht an den Nichtbildstellen durch Entschichten und gegebenenfalls Ätzen der freigelegten Trägeroberfläche. Die Erfindung ist gekennzeichnet durch die Kombination der Verwendung eines Aufzeichnungsmaterials, dessen photoleitfähige Schicht mindestens ein organisches nleitendes Pigment in einer Konzentration zwischen 10 und 50 Gewichtsprozent und einen organischen p-leitenden Photoleiter in einer Konzentration von Null bis 20 Gewichtsprozent, bezogen auf das Schichtgewicht, zusammen mit einem in wäßrig-alkalischer Lösung löslichen oder dispergierbaren Bindemittel enthält, und der Durchführung der Entschichtung mit einer wäßrig-alkalischen Entschichterlösung, die vorzugsweise Alkalimetallhydroxide und/oder -phosphate enthält. Die Entschichtung wird vorzugsweise bei erhöhter Temperatur, etwa 30 bis 60 °C, durchgeführt.

# VERFAHREN ZUM HERSTELLEN VON DRUCKFORMEN

Die Erfindung betrifft ein Verfahren zum Herstellen von Druckformen oder metallisierten Bildern auf elektrophotographischem Wege durch elektrostatisches Aufladen, bildmäßiges Belichten und Betonern einer auf einem elektrisch leitenden Trägermaterial aufgebrachten Photoleiterschicht, Fixieren der mit Toner versehenen Bildstellen, Entfernen der Photoleiterschicht an den Nichtbildstellen durch Entschichten und gegebenenfalls Ätzen der freigelegten Trägeroberfläche.

Verfahren zur Herstellung von Druckformen oder gedruckten Schaltungen, wie Offset-Druckplatten, auf elektrophotographischem Wege sind bekannt. So lassen sich zum Beispiel Offsetdruckplatten mit einer Zinkoxid enthaltenden Photoleiterschicht dadurch herstellen, daß man die nach der Entwicklung bildmäßig mit Toner bedeckte Platte mit einem Hydrophilierungsmittel, etwa durch Behandlung mit Ferricyanid-Lösung, gezielt an den Nichtbildstellen hydrophiliert. Hierdurch wird eine Differenzierung zwischen Farbe annehmenden, hydrophoben, betonerten Bildstellen und der hydrophil eingestellten Schichtoberfläche erzielt. Nachteilig bei einem derartigen Verfahren ist die Notwendigkeit, den Hydrophilierungsschritt öfters wiederholen zu müssen, und die relativ geringe Druckauflage.

Um die beschriebenen Nachteile zu beheben, ging man bei elektrophotographisch vorsensibilisierten Offsetdruckplatten auf Systeme über, bei denen der Hydrophilierungsschritt durch einen Entschichtungsschritt ersetzt werden konnte. So läßt sich gemäß DE-AS 11 17 391, entsprechend GB-PS 944,126, eine Bilddifferenzierung dadurch erreichen, daß man als Bindemittel der photoleitfähigen Schicht eine hochmolekulare, alkalilöslich machende Gruppen enthaltende Verbindung verwendet. Durch Betonern und Fixieren der betonerten Bildstellen wird eine Maske ausgebildet, die die Entschichtung mit einem alkalisch eingestellten Entschichter auf die Nichtbildstellen der Photoleiterschicht beschränkt. Durch Verwendung eines hydrophilen Schichtträgers, etwa einer elektrochemisch oder mechanisch aufgerauhten und anodisierten Aluminiumunterlage, wird so eine Differenzierung zwischen hydrophobem Tonerbild bzw. hydrophober Photoleiterschicht und der freigelegten hydrophilen Schichtträgeroberfläche erreicht.

Zur Entschichtung verwendet man Lösungen von anorganischen und/oder organischen alkalischen Substanzen in Wasser und/oder organischen Lösungsmitteln. Als besonders geeignet werden schwerflüchtige Amine oder Aminoalkohole betrachtet, die in Konzentrationen zwischen etwa 1 und 5 % als Lösung in mehrwertigen Alkoholen und/oder Wasser angewandt werden. Die Applizierung kann sowohl durch einfaches Überwischen, zum Beispiel mit einem getränkten Wattebausch, durch Eintauchen in ein Entschichtungsbad oder durch entsprechende maschinelle Vorrichtungen, in denen die alkalische Flüssigkeit angetragen wird, erfolgen.

Es ist bekannt (DE-AS 11 17 391 oder DE-PS 23 22 046, entsprechend GB-PS 1 465 926), daß man besonders dann gute Entschichterwirkungen erhält, wenn der Entschichter Lösungsmittel, insbesondere Alkohole, enthält. Diese sind in der Lage, den in den genannten Schichten in der Bindemittelmatrix gelöst vorliegenden organischen Photoleiter zu lösen und dadurch den Entschichtungsschritt zu beschleunigen. Dies ist von besonderer Bedeutung für die maschinelle Verarbeitung, bei der große Anforderungen an Entschichtungsgeschwindigkeit und Entschichterstandzeit gestellt werden. Lösungsmittelhaltige Entschichter bieten darüberhinaus Vorteile hinsichtlich der Maschinenverschmutzung, da sie durch ihr Lösungsvermögen für den Photoleiter dessen unerwünschte Ablagerung in dem Gerät verhindern. Lösungsmittelfreie Entschichter können hierzu nicht verwendet werden.

Lösungsmittelhaltige Entschichter weisen andererseits eine Reihe von Nachteilen auf. So läßt sich beim Einsatz von Aminen in der Regel eine gewisse Geruchsbelästigung nicht vermeiden. Aus Sicherheitsgründen ist weiterhin die Auswahl der einzusetzenden Lösungsmittel hinsichtlich ihres Flammpunktes eingeschränkt, oder aber es müssen aufwendige Sicherheitsmaßnahmen getroffen werden. Schließlich zeigt der Toner des Entwicklers -in der Regel Polymerisate ohne alkalilöslich machende Gruppen -häufig eine gewisse Löslichkeit oder Quellbarkeit in den verwendeten Lösungsmitteln. -Dies gilt insbesondere für Flüssigentwickler des Dispersimertyps, wie sie zum Beispiel aus DE-AS 21 14 773, entsprechend US-PS 3 753 760, bekannt sind. Durch Löslichkeit oder Quellbarkeit des fixierten Toners kommt es während des Entschichtungsschrittes zu nicht unerheblichen Verlusten, besonders bei feinen Bildelementen. Da der Entschichter durch die Tonermaske hindurch auch die darunter befindliche Photoleiterschicht angreift, kann es weiterhin zu einer Unterätzung und zum anschließenden Abschwimmen der Tonermaske kommen. Gleiches gilt, bedingt durch das andere Herstellungsverfahren, in vermindertem Umfang auch für Tonermasken aus Trockenentwickler.

Der Übergang zu photoleitfähigen Schichten mit geringeren Anteilen an in dem Bindemittel gelöstem Photoleiter und recht hohen Gehalten an photoleitfähigen organischen Pigmenten zur Herstellung von Druckformen, wie sie in der deutschen Patentanmeldung, Aktenzeichen P 34 17 951.8, beschrieben werden, führt bei Verwendung lösungsmittelhaltiger Photoleiterschichten zu unerwünschten, wesentlich langsameren Entschichtungsgeschwindigkeiten, die für eine praktische Anwendung nicht mehr ausreichen. Eine vollständige Entschichtung kann in diesen Fällen nicht gewährleistet werden.

Der vorliegenden Erfindung lag die Aufgabe zugrunde, ein Verfahren zur Verfügung zu stellen, das es ermöglicht, Druckformen oder metallisierte Bilder mit Aufzeichnungsmaterialien mit photoleitfähigen Schichten, die einen hohen Anteil an organischen Pigmenten und geringe Mengen an in dem Bindemittel gelöstem organischem Photoleiter besitzen, zu verarbeiten. Das Verfahren sollte gleichzeitig eine gute Differenzierung zwischen betonerten und nichtbetonerten Stellen bei Verwendung sowohl von Flüssig-wie von Trockenentwickler ermöglichen und sollte -hinsichtlich Standzeit wie Entschichtungsgeschwindigkeit -eine Verwendung in maschineller Bearbeitung sicherstellen.

Die Lösung dieser Aufgabe geht aus von einem Verfahren zum Herstellen von Druckformen oder metallisierten Bildern der eingangs genannten Art und ist gekennzeichnet durch die Kombination der Verwendung eines Aufzeichnungsmaterials, dessen photoleitfähige Schicht mindestens ein organisches n-leitendes Pigment in einer Konzentration zwischen 10 und 50 Gewichtsprozent und einen organischen p-leitenden Photoleiter in einer Konzentration von Null bis 20 Gewichtsprozent, bezogen auf das Schichtgewicht, zusammen mit einem in wäßrig-alkalischer Lösung löslichen oder dispergierbaren Bindemittel enthält, und der Durchführung der Entschichtung mit einer wäßrig-alkalischen Entschichterlösung. In bevorzugter Ausführungsform verwendet man eine Entschichterlösung, die Alkalimetallhydroxide und/oder -phosphate, vorzugsweise in einer Konzentration von 0,01 bis 10 Gewichtprozent, enthält.

Hierdurch wird erreicht, daß elektrophotographische Aufzeichnungsmaterialien mit der beschriebenen Photoleiterschicht zur Herstellung von Druckformen oder metallierten Bildern in technisch hohen Anforderungen genügender Weise einsetzbar gemacht werden. Die erfindungsgemäßen Entschichterlösungen besitzen eine gute Entschichtungsgeschwindigkeit und eine zufriedenstellende Standzeit. Es war überraschend, daß erfindungsgemäß eingesetzte Entschichterlösungen besonders feine Bildelemente wiedergaben und Unterätzungen vermieden wurden.

Die erfindungsgemäß einsetzbaren Aufzeichnungsmaterialien besitzen einen relativ hohen Gehalt an photoleitfähigen organischen Pigmenten, die in Bindemittel eingebettet sind, die in wäßrig-alkalischer Lösung löslich oder dispergierbar sind. Zur Erhöhung der elektrophotographischen Empfindlichkeit können derartige Photoleiterschichten auch zusätzlich geringe Mengen eines organischen p-Leiters enthalten. So lassen sich zum Beispiel die in der deutschen Patentanmeldung, Aktenzeichen P 34 17 951.8 beschriebenen Materialien aus photoleitfähigem organischen Pigment und carbonylgruppenhaltigem Bindemittel dann einsetzen, wenn dieses Bindemittel durch Einbau von Carbonsäure-oder Carbonsäureanhydridgruppierungen in wäßrig-alkalischer Lösung löslich oder dispergierbar gemacht wurde. Als Bindemittel kommen bevorzugt Copolymerisate aus Methacrylsäureestern und Methacrylsäure, gegebenenfalls mit weiteren Monomeren, wie Styrol, in Frage. Über die bekannten Bindemittel mit Carbonylfunktion hinaus lassen sich mit dem erfindungsgemäßen Verfahren auch solche Schichten verarbeiten, deren Bindemittel zum Beispiel Sulfonsäure-, Phosphonsäure-, Kohlensäure-und ähnliche, alkalilöslich machende Gruppierungen aufweisen.

Als wäßrig-alkalische Entschichterlösungen kommen Lösungen von anorganischen Substanzen in Wasser zur Anwendung. Als anorganische, alkalische Substanzen sind Ammoniak, Alkalimetall-und Erdalkalimetallhydroxide, Alkalimetall-und Erdalkalimetallphosphate, -hydrogenphosphate, -carbonate, -silikate, -borate u.ä. geeignet. Vorzugsweise werden Alkalimetallhydroxide und -phosphate eingesetzt. Die genannten Substanzen werden in wäßriger Lösung in Konzentrationen zwischen etwa 0,01 und 10, bevorzugt zwischen 1 und 5 Gewichtsprozent, eingesetzt. Der Entschichterlösung können in geringer Menge organische Lösungsmittel zugesetzt werden, ohne daß sich die guten Eigenschaften des Entschichters verändern. In bevorzugter Ausführung wird auf den Zusatz organischer Lösungsmittel verzichtet.

Um die Entschichtungsgeschwindigkeit zu erhöhen und um die Verschmutzung der Entschichtungsapparatur zu minimieren, hat es sich als vorteilhaft erwiesen, der Entschichterlösung geeignete Dispergiermittel zuzusetzen. Als solche lassen sich grundsätzlich alle anionischen, kationischen und nichtionischen Tenside, die für wäßrige Systeme geeignet sind, einsetzen. Beispiele sind Alkylsulfonate, -phosphonate, Alkalisalze der Fettalkoholhalbester der Schwefelsäure, Fettaminderivate, Oligomere des Ethylenoxids mit geeigneten Endgruppen, wie Nonylphenol, und Siloxane. Als besonders geeignet hinsichtlich der Steigerung der Entschichtungsgeschwindigkeit und der Stabilisierung des anfallenden abgelösten Pigments in der entstehenden Entschichterdispersion haben sich die Alkali-alkylsulfate, wie Natrium-octylsulfat, erwiesen. Die Dispergiermittel werden der Entschichterlösung in Konzentrationen zwischen etwa 0,1 und 5 Gewichtsprozent zugesetzt. Besonders gute Resultate werden bei Konzentrationen zwischen 0,5 und 3 Gewichtsprozent erzielt.

Bei der Anwendung zur Herstellung von Offsetdruckplatten auf anodisiertem Träger hat es sich als vorteilhaft erwiesen, Substanzen zuzusetzen, die die anodisierte Aluminium/Aluminiumoxid-Oberfläche vor einem Angriff durch die Entschichterlösung schützen. Als solche kommen Silikate in Frage.

Um insbesondere bei maschineller Entschichtung die Standzeit des Entschichters zu erhöhen und die Entschichtungsbedingungen konstant zu halten, hat es sich als günstig erwiesen, den pH der Entschichterlösung entweder durch die Zugabe eines Puffers, wie z.B. des Phosphatpuffers oder anderer in der Literatur beschriebener Puffersysteme, oder durch Nachdosierung mit einem Konzentrat höheren pHs konstant zu halten.

Die Entschichtung kann bei Raumtemperatur durchgeführt werden. Sie kann aber auch bei erhöhter Temperatur erfolgen. Vorzugsweise wird die Entschichtung im Bereich von 30 bis 60 °C durchgeführt.

Die Entwicklung lichtempfindlicher, auf nichtelektrophotographischer Basis arbeitender Flachdruckplatten bei erhöhter Temperatur ist an sich bekannt. So offenbart DE-OS 25 04 130, entsprechend japanischer Offenlegungsschrift 50-108005, daß man bei positiv wie negativ arbeitenden Systemen, die durch Photoreaktion chemisch zwischen Bild-und Nichtbildstellen unterscheiden, durch Erhöhung der bei der Entwicklung herrschenden Temperatur auch das Arbeiten mit über eine längere Zeit gelagerten Druckplatten ermöglicht. Die eingesetzten Entwicklerlösungen weisen Komponenten auf, die bei Atmosphärendruck einen Siedepunkt von oberhalb 80 °C besitzen. Die Lösungen sind stark lösungsmittelhaltig. Eine technische Anwendung dieses Verfahrens ist jedoch nicht bekannt geworden.

Elektrophotographische Aufzeichnungsmaterialien dagegen weisen in der Regel erheblich größere Schichtdicken für die Photoleiterschicht auf als die Schichten der oben beschriebenen lichtempfindlichen Systeme. Im Gegensatz zu diesen wird bei elektrophotographischen Systemen auf physikalischem Weg zwischen Bild-und Nichtbildstellen unterschieden, indem erstere durch eine Tonermaske abgedeckt werden. Die Photoleiterschicht unter dieser Tonermaske wird in ihrer chemischen Zusammensetzung und damit in ihrem Verhalten einer Entschichterlösung gegenüber nicht verändert.

Lösungsmittelhaltige Entschichter führen zu einem Anquellen nicht nur der nicht durch eine Tonermaske geschützten Nichtbildstellen der Photoleiterschicht, sondern auch des Toners. Die Folge ist ein Anquellen bzw. Lösen auch der unter der Tonermaske gelegenen Bildstellen der Photoleiterschicht. Dies führt zu Bildverlusten auf der Druckform oder zu Schwachstellen der hydrophoben Schicht, die im Verlaufe des Drucks zu Bildverlusten auf dem Informationsträger führen.

Es hat sich nun gezeigt, daß durch Verwendung lösungsmittelfreier Entschichter der Angriff auf die Nichtbildstellen der Photoleiterschicht beschränkt bleibt, die oben genannten Entschichtungsfehler werden -was nicht ohne weiteres zu erwarten war -nicht beobachtet. Überraschenderweise ändert an diesem Entschichtungsverhalten auch eine Erhöhung der Temperatur nichts. Sie führt im Gegenteil zu einer hervorragenden Differenzierung zwischen Bild-und Nichtbildstellen selbst bei den hinsichtlich der Entschichtung empfindlicheren Flüssigtonermasken. Im Gegensatz zur allgemeinen Ansicht, daß das Kohlendioxid-Problem mit steigender Temperatur zu einer drastischen Abnahme der Standzeit des Entschichters führt, wird in der Praxis eine Erhöhung der Standzeit beobachtet, solange mit rein wäßrig-alkalischen Entschichtern gearbeitet wird. Eine Kontrolle über die Belastung des Systems ist über eine relativ einfache pH-Messung möglich, eine Nachdosierung unproblematisch.

Als für die Entschichtung der Pigmentschichten geeigneter Temperaturbereich hat sich ein Bereich zwischen etwa 30 und 60 °C als besonders geeignet herausgestellt. Die untere Grenze dieses Bereichs erlaubt eine Reduzierung des erforderlichen Regelaufwands für die Temperatur, verglichen mit einer maschinellen Entschichtung bei Raumtemperatur. Die obere Grenze ist weniger stark umrissen und wird im wesentlichen durch den Dampfdruck des Wassers und gegebenenfalls erforderliche Sicherheitsmaßnahmen beim Umgang mit den jeweiligen aufgeheizten Entschichterlösungen festgelegt.

Eine Entwicklung des latenten elektrostatischen Bildes kann sowohl mit einem Trockenentwickler als auch in einem Flüssigentwickler erfolgen. Das Entwickeln durch Betonern mit einem Flüssigentwickler wird bei dem erfindungsgemäßen Verfahren bevorzugt.

Zur Herstellung metallisierter Ätzbilder werden metallisierte Kunststoffträger in Form von Folien oder Platten eingesetzt, wobei die Metallschicht durch Aufdampfen, Aufkaschieren oder durch chemische oder galvanische Abscheidung aufgebracht werden kann. Hier wird nach dem Entschichten die freigelegte Schichtträgeroberfläche geätzt.

Ein weiterer Vorteil bei der Verwendung des erfindungsgemäßen Verfahrens besteht schließlich in der relativ einfachen Entsorgung der anfallenden verbrauchten Entschichterlösung. Durch einfache Neutralisierung mit in der Chemie gebräuchlichen Säuren, wie zum Beispiel Salzsäure, oder durch Brechen der Dispersion durch Zugabe von Substanzen, die das Dispergiermittel komplexieren oder ausfällen, oder in seinem Dissoziationsverhalten beeinflussen, wie im Fall des Natriumoctylsulfats durch Zugabe von Kalkmilch oder Natriumchlorid, wird ein Großteil der ursprünglichen Schichtbestandteile ausgefällt und kann durch einen Filtrationsschritt entfernt werden. Der anfallende Filterkuchen kann gegebenenfalls einer Wiederaufarbeitung zugeführt werden, bei der die Schichtkomponenten isoliert und wiederum zur Herstellung von vorsensibilisierten Offsetdruckplatten eingesetzt werden können.

Die Erfindung wird anhand der folgenden Beispiele und Vergleichsbeispiele näher erläutert, ohne sie hierauf zu beschränken.

Beispiel 1

Auf eine elektrochemisch vorbehandelte und anodisierte Aluminiumplatte wurde die folgende Dispersion so aufgetragen, daß sich ein Trockenschichtgewicht von 6 g/m² ergab:

15 g N,N'-(3-methoxyphenyl)perylen-tetracarbonsäure-3,4,9,10-diimid (Paliogen[R] schwarz, BASF AG),

3 g 4-Methoxy-benzaldehyd-diphenylhydrazon,

42 g eines Terpolymerisates aus Styrol, Hexylmethacrylat und Methacrylsäure im Molverhältnis 10:60:30

in

540 g Tetrahydrofuran.

Die Schicht wurde nach elektrostatischem Aufladen (negativ) mittels einer Corona bildmäßig belichtet und mit einem handelsüblichen Trockenentwickler mit positiv aufgeladenen Tonerteilchen behandelt. Das Tonerbild wurde bei 150 °C während 5 Minuten fixiert. Die Entschichtung erfolgte an einem handelsüblichen Entschichtungsgerät unter Verwendung der folgenden Entschichterlösungen:

a) 50 Gewichtsteile Isopropanol,

10 Gewichtsteile Benzylalkohol,

4 Gewichtsteile Kaliumhydroxid,

36 Gewichtsteile Wasser,
b) 5,6 Gewichtsteile Kaliumhydroxid,

994,4 Gewichtsteile Wasser,
c) 5,6 Gewichtsteile Kaliumhydroxid,

20 Gewichtsteile Natriumoctylsulfat,

974,4 Gewichtsteile Wasser,
d) 7,1 Gewichtsteile Dinatriumphosphat,

2,2 Gewichtsteile Natriumhydroxid,

1529 Gewichtsteile Wasser,
e) 2,75 Gewichtsteile Natriumhydroxid,

4 Gewichtsteile Natriumsilikat-Nonahydrat,

3,75 Gewichtsteile n-Butylglykol und

389,5 Gewichtsteile Wasser.

Dabei wurden die in der beigefügten Tabelle aufgeführten Entschichtungsgeschwindigkeiten erreicht. Durch den Dispergiermittelzusatz nach Lösung c) wurde eine deutlich stabilere Dispersion des Farbpigments der Entschichterlösung erhalten, Schichtbestandteile setzten sich im Entschichtervorratsgefäß nicht ab. Ein Standzeitversuch ohne pH-Nachregelung ergab für das Beispiel c) den günstigsten Verbrauchswert von 125 ml/m², wobei die Temperatur von anfänglich 33 °C auf 39 °C am Ende der Versuchsreihe in kleinen Temperaturschritten von 1 °C erhöht und die Entschichtungsgeschwindigkeit konstant gehalten wurde.

Vergleichsbeispiel 1

Es wurde vorgegangen wie in Beispiel 1, mit dem Unterschied, daß anstelle der Pigmentplatte eine Platte eingesetzt wurde, die auf einem entsprechend vorbehandelten Aluminiumträger eine 6 g/m² dicke Schicht, bestehend aus 50 Gewichtsteilen eines Copolymerisates aus Maleinsäurehalbester und Styrol (Scripset [R] 540, Monsanto), 50 Gewichtsteilen des Photoleiters Bis-(N,N-diethylamino-phenyl)-oxdiazol-1,3,4 und 0,5 Gewichtsteilen Rhodamin B, trug.

*Eine Entschichtung mit Entschichtervarianten*
b) und c) erweist sich bei, verglichen mit Beispiel 1, deutlich erhöhten Temperaturen zwar als möglich, es kommt jedoch zur Redeponierung von Schichtbestandteilen auf den Transportwalzen des Entschichtungsgeräts.

Beispiel 2

Es wurde vorgegangen wie in Beispiel 1, mit dem Unterschied, daß anstelle eines Trockenentwicklers ein Flüssigentwickler auf Dispersimerbasis gemäß DE-AS 21 14 773 eingesetzt wurde.

Bei gegenüber Beispiel 1 unveränderten Entschichtungsbedingungen wurden bei Verwendung der lösungsmittelhaltigen Entschichterlösung a) deutliche Verluste bei den Spitzpunkten von Rasterfeldern beobachtet. Eine Erhöhung der Entschichtungsgeschwindigkeit ergab hier zwar eine Verbesserung, führte aber zu nicht vollständiger Entschichtung in Nichtbildstellen und Tiefen. Die Entschichtervarianten b) und c) hingegen ergaben grundfreie Bildwiedergaben bei hervorragender Wiedergabe sowohl der Tiefen als auch der Spitzpunkte.

*Vergleichsbeispiel 2*

Es wurde vorgegangen wie in Beispiel 1, mit dem Unterschied, daß eine Entschichterlösung aus

180 Gewichtsteilen Propanol-2,

20 Gewichtsteilen Benzylalkohol,

2,5 Gewichtsteilen Monoethanolamin und

3 Gewichtsteilen Na-octylsulfat

verwendet wurde. Diese Entschichterlösung entspricht in ihrer Zusammensetzung der in der DE-OS 25 04 130, Beispiel 1, aufgeführten Entwicklerlösung für chemisch differenzierende Diazoschichten und führt dort zu guten Resultaten. Bei ihrem Einsatz als Entschichterlösung für hochpigmentierte elektrophotographische Schichten wurde unter diesen Bedingungen das Tonerbild, hergestellt sowohl durch Trocken-als auch durch Flüssigentwickler, massiv angegriffen. Feine Bildelemente gingen während des Entschichtungsprozesses verloren.

## Tabelle

| Schicht | Entschichterlösung | Temperatur (Entschichtung °C) | Entschichtungsgeschwindigkeit m/min | Wiedergabe von Spitzpunkt | Wiedergabe von Tiefe | Wiedergabe von Grund |
|---|---|---|---|---|---|---|
| Beispiel 1 | a | 26 | 1,4 | − | − | − |
| | b | 33 | 1,7 | + | + | + |
| | c | 33 | 1,7 | ++ | ++ | ++ |
| | c | 55 | 4,3 | ·+ | ·+ | ·+ |
| | d | 33 | 1,7 | + | + | + |
| | e | 26 | 1,7 | + | + | + |
| Vergleichsbeispiel 1 | a | 26 | 1,9 | + | + | + |
| | b | 50 | 0,4 | + | + | + |
| | c | 50 | 0,9 | + | + | + |

− schwach
+ gut
++ sehr gut

## Ansprüche

1. Verfahren zum Herstellen von Druckformen oder metallisierten Bildern auf elektrophotographischem Wege durch elektrostatisches Aufladen, bildmäßiges Belichten und Betonern einer auf einem elektrisch leitenden Trägermaterial aufgebrachten Photoleiterschicht, Fixieren der mit Toner versehenen Bildstellen, Entfernen der Photoleiterschicht an den Nichtbildstellen durch Entschichten und gegebenenfalls Ätzen der freigelegten Trägeroberfläche, gekennzeichnet durch die Kombination der Verwendung eines Aufzeichnungsmaterials, dessen photoleitfähige Schicht mindestens ein organisches n-leitendes Pigment in einer Konzentration zwischen 10 und 50 Gewichtsprozent und einen organischen p-leitenden Photoleiter in einer Konzentration von Null bis 20 Gewichtsprozent, bezogen auf das Schichtgewicht, zusammen mit einem in wäßrig-alkalischer Lösung löslichen oder dispergierbaren Bindemittel enthält, und der Durchführung der Entschichtung mit einer wäßrig-alkalischen Entschichterlösung.

2. Verfahren nach Anspruch 1, dadurch gekennzeichnet, daß man eine Entschichterlösung verwendet, die Alkalimetallhydroxide und/oder -phosphate enthält.

3. Verfahren nach Ansprüchen 1 oder 2, dadurch gekennzeichnet, daß man eine Entschichterlösung verwendet, die Alkalihydroxide und/oder -phosphate in einer Konzentration von 0,01 bis 10 Gewichtsprozent enthält.

4. Verfahren nach Ansprüchen 1 bis 3, dadurch gekennzeichnet, daß man eine Entschichterlösung verwendet, die zusätzlich ein Dispergiermittel enthält.

5. Verfahren nach Ansprüchen 1 bis 4, dadurch gekennzeichnet, daß man eine gepufferte Entschichterlösung verwendet.

6. Verfahren nach Ansprüchen 1 bis 5, dadurch gekennzeichnet, daß man die Entschichtung bei erhöhter Temperatur durchführt.

7. Verfahren nach Anspruch 6, dadurch gekennzeichnet, daß man die Entschichtung bei einer Temperatur im Bereich von 30 bis 60 °C durchführt.

8. Verfahren nach Anspruch 1 bis 7, dadurch gekennzeichnet, daß man eine Entschichterlösung verwendet, die zusätzlich Silikate enthält.

9. Verfahren nach Anspruch 1, dadurch gekennzeichnet, daß man in der photoleitfähigen Schicht Copolymerisate aus Methacrylsäureestern und Methacrylsäure, gegebenenfalls mit weiteren Monomeren, wie Styrol, als Bindemittel verwendet.

10. Verfahren nach Anspruch 1, dadurch gekennzeichnet, daß man das Betonern mit einem Flüssigentwickler durchführt.